# EUROPÄISCHE PATENTANMELDUNG

(11) **EP 2 166 576 A2**
(43) Veröffentlichungstag der Anmeldung: **24.03.2010**
(21) Anmeldenummer: 09011524.7
(22) Anmeldetag: 09.09.2009
(51) Int. Cl.: H01L 31/048, B29C 45/14

(54) **Verfahren und Vorrichtung zur Herstellung eines Solarmoduls**

(30) Priorität: 19.09.2008 DE 102008048160
(71) Anmelder: KraussMaffei Technologies GmbH, 80997 München (DE)
(72) Erfinder: Kern, Hans-Jürgen, 83093 Bad Endorf (DE); Frehsdorf, Wolfgang, 80802 München (DE)
(74) Vertreter: Zollner, Richard

(57) **Zusammenfassung**

Die vorliegende Erfindung betrifft ein Verfahren und eine Vorrichtung zur Herstellung eines Solarmoduls. Dabei wird eine Trägerstruktur (12) in die Aufnahme (30) eines zweiten Formwerkzeugs (26) eingebracht, die Trägerstruktur (12) mittels eines niedrigviskosen, vernetzenden Material (18), insbesondere mittels eines Polyurethan-Materials vollständig überflutet, wobei das vernetzende Material (18) zumindest teilweise ausreagiert, so dass die Trägerstruktur (12) zumindest teilweise beschichtet ist, Photovoltaik-Zellen (14) auf die überflutete Trägerstruktur aufgebracht, wobei die Unterseiten der Photovoltaik-Zellen (14) vollflächig auf der Beschichtung aufliegen, und die Oberseiteseite der Photovoltaik-Zellen (14) mit einem niedrigviskosen vernetzenden Material (18') beschichtet, welches im ausgehärteten Zustand lichtdurchlässig ist.

## Beschreibung

Die vorliegende Erfindung betrifft ein Verfahren sowie eine Vorrichtung zur Herstellung einer Solarzelle, bei der Photovoltaik-Zellen eingegossen und auf einer Trägerstruktur aufgebracht sind gemäß den Oberbegriffen der Ansprüche 1 bzw. 16.

Es ist bereits bekannt, Solarmodule herzustellen, bei denen Photovoltaik-Zellen in ein Gießsystem, insbesondere in einem Polyurethanmaterial eingebettet werden. Eine solche Lehre ist aus der DE 101 01 770 A1 bekannt. Dabei wird das Solarmodul zumindest auf der Frontseite mit einem transparenten Polyurethan versehen. Polyurethan bietet nämlich im Vergleich zu anderen Materialien eine hohe Witterungsstabilität, den Vorteil geringer Materialkosten sowie eine niedrige Dichte. Im Übrigen wird auch auf die DE 20 2006 015928 hingewiesen.

Gemäß einer Ausführungsform zur Herstellung eines solchen Solarmoduls können die Photovoltaik-Zellen in einem Schritt mit transparentem Polyurethan umspritzt werden. In einer anderen Ausführungsform erfolgt die Herstellung der Solarmodule durch ein Verfahren, bei dem transparentes Polyurethan in einem Schritt auf einem als Modulrückseite dienenden Bauteil fixierte Solarzelle aufgespritzt wird. In einer weiteren Ausführungsform kann entweder in einem ersten Schritt eine transparente Polyurethan-Frontseite und in einem zweiten Schritt die Polyurethan-Rückseite oder anderenfalls in umgekehrter Reihenfolge das Polyurethanmaterial auf die Solarzellen aufgespritzt werden.

Dabei wird in der Regel bisher so vorgegangen, dass die Photovoltaik-Zellen auf Halterungen oder Stützen angeordnet werden. Dies ist insofern nachteilig, als beim Einbringen des Polyurethanmaterials keine vollflächige Abstützung vorliegt und es aufgrund der Druckbelastungen teilweise zu einem Brechen oder einer Beschädigung der Photovoltaik-Zellen kommt.

Aufgabe der vorliegenden Erfindung ist es, ein Solarmodul so herzustellen, dass die Photovoltaik-Zellen möglichst unbeschädigt sind.

Diese Aufgabe wird verfahrensmäßig durch die im Anspruch 1 genannten Merkmale und vorrichtungsmäßig durch die im Anspruch 16 genannten Merkmale gelöst.

Demgemäß ist ein Gedanke der vorliegenden Erfindung darin zu sehen, die Photovoltaik-Zellen vollständig in ein vernetzendes Material, beispielsweise ein Polyurethanmaterial einzuhüllen, wobei beim ersten Überflutungsvorgang eine Trägerstruktur überflutet wird und in einem zweiten Schritt die Photovoltaik-Zellen auf die derart beschichtete Trägerstruktur aufgebracht werden. Bei diesem zweiten Schritt kommen die Photovoltaik-Zellen vollflächig auf der Beschichtung zu liegen, wodurch vermieden werden kann, dass beim weiteren Über- und Eingießvorgang die Photovoltaik-Zellen durch eine Druckbelastung beschädigt oder gar zerstört werden. Durch die vollflächige Auflage wird nicht nur das gesamte Photovoltaik-Element über seine ganze Fläche abgestützt.

Nach dem Aufbringen der Photovoltaik-Zellen auf die vorher hergestellte Beschichtung der Photovoltaik-Zellen wird das vollständige Überfluten der Vorder- bzw. Oberseite der Photovoltaik-Zellen durchgeführt, wodurch man ein einheitliches Solarzellengebilde erhält. Dabei ist natürlich notwendig, dass zumindest die obere Beschichtung der Solarzelle, also das im zweiten Schritt eingebrachte vernetzende oder Polyurethanmaterial, lichtdurchlässig ausgebildet ist.

Als Trägerstruktur eignen sich nahezu alle Materialien. Besonders vorteilhaft hat sich jedoch die Verwendung von Polycarbonat oder Styrol-Acrylnitril-Copolymer (SAN) als Trägerstrukturmaterial herausgestellt.

Vom verfahrensmäßigen Ablauf scheint es besonders einfach zu sein, die Trägerstruktur zunächst zu überfluten, um so eine geeignete Ablage für die Photovoltaik-Zellen zu erhalten und die Photovoltaik-Zellen gesondert zu positionieren. Dabei muss man einfach das niedrig viskose, vernetzende Material auf die in einer Form angebrachte Trägerstruktur aufgießen.

Die Positionierung der Photovoltaik-Zellen kann beispielsweise durch Aufeinander-Verschwenken von Formwerkzeughälften geschehen oder auch einfach durch eine Robotvorrichtung, die die leitend miteinander verbundenen Photovoltaik-Zellen auf der beschichteten Trägerstruktur positioniert. Für den Fall, dass dabei das vernetzende Material auf der Oberseite der Trägerstruktur noch nicht voll ausreagiert ist, findet beim Zusammenfügen eine Verbindung zwischen den einzelnen Elementen statt, wodurch diese Elemente dabei formschlüssig zusammengefügt werden. Auch eine ganzflächige Auflage der einzelnen Photovoltaik-Zellen auf die Beschichtung wird dadurch sichergestellt.

Sollte es bei irgendeinem Übergießprozess oder bei dem Zusammenpressen zu einem Überlauf von Material kommen, so wird dieses überschüssige Material nachfolgend abgetrennt.

Äußerst nachteilig ist es, wenn in der vernetzten Deckschicht, also der Polyurethanschicht, insbesondere auf der Oberfläche, Luftblasen oder Lufteinschlüsse vorhanden sind. Derartige Lufteinschlüsse vermindern punktuell die Transmission der Deckschicht und somit die photoelektrische Ausbeute des gesamten Moduls. Aus diesem Grunde sollte sichergestellt werden, dass solche Lufteinschlüsse nicht vorhanden sind. Insbesondere, wenn die Gefahr für solche Lufteinschlüsse besteht, sollten diese nach dem Aufbringen des vernetzenden Materials - zumindest des Materials für die Oberfläche der Solarzelle - entfernt werden. Dies kann beispielsweise durch Anlegen eines Vakuums oder durch Anwenden von Wärme auf der Oberfläche mittels einer Heizquelle geschehen.

Natürlich können vor oder nach dem Aufbringen der vernetzenden Materialien weitere Schichten, insbesondere Folien oder Plasma-Funktionsschichten, aufgebracht werden, die verschiedene Funktionen erfüllen können.

Beim Handling der Trägerstruktur und/oder des Zwischenproduktes können diese Zellen mittels Unterdruck an den Formwerkzeugen oder sonstigen Handlingsgeräten gehalten werden.

Um zu vermeiden, dass sich die in ein Werkzeug eingebrachten Photovoltaik-Zellen aus ihrer Ordnungsstruktur verschieben, können diese vor dem Ein- oder Aufbringen auf einer Folie angeordnet (angeheftet) sein. Diese Folie wird dann nach dem Aufbringen der Photovoltaik-Zellen auf die beschichtete Trägerstruktur abgenommen, so dass dann die Oberseiten der Photovoltaik-Zellen frei zugänglich sind.

Weitere Merkmale und Vorteile der vorliegenden Erfindung sind in den Ansprüchen formuliert.

Die vorliegende Erfindung wird nunmehr anhand eines konkreten Ausführungsbeispiels und mit Bezug auf die beiliegenden Zeichnungen näher erläutert. Die Zeichnungen zeigen in
- Fig. 1: ein in fertigem Zustand nach dem erfindungsgemäßen Verfahren hergestelltes Solarmodul
- Fig. 2: eine schematische Darstellung einer beispielhaften Vorrichtung zur Durchführung des erfindungsgemäßen Verfahrens, wobei die Vorrichtung noch unbefüllt ist,
- Fig. 3: eine schematische Darstellung der Vorrichtung aus Fig. 2, nun mit eingesetzter Trägerstruktur und Photovoltaik-Zellen,
- Fig. 4: eine schematische Darstellung der Vorrichtung aus Fig. 2, mit beschichteter Trägerstruktur,
- Fig. 5: eine schematische Darstellung der Vorrichtung aus Fig. 2 in zusammengeklapptem Zustand,
- Fig. 6: eine schematische Darstellung der wieder geöffneten Vorrichtung aus Fig. 2, wobei nunmehr ein Oberwerkzeug aufgesetzt ist,
- Fig. 7: eine schematische Darstellung eines in der Vorrichtung aus Fig. 2 fertiggestellten Solarmoduls,
- Fig. 8: eine schematische Darstellung einer zweiten Ausführungsform einer Vorrichtung zur Durchführung des erfindungsgemäßen Verfahrens, wobei die Vorrichtung noch unbefüllt ist,
- Fig. 9: eine schematische Darstellung der Vorrichtung aus Fig. 8, nun mit eingesetzter Trägerstruktur, Zellenträgerplatte und Photovoltaik- Zellen,
- Fig. 10: eine schematische Darstellung der Vorrichtung aus Fig. 8, mit beschichteter Trägerstruktur,
- Fig. 11: eine schematische Darstellung der Vorrichtung aus Fig. 8 in zusammengeklapptem Zustand
- Fig. 12: eine schematische Darstellung der wieder geöffneten Vorrichtung aus Fig. 2, wobei nunmehr die Zellenträgerplatte entnommen ist und
- Fig. 13: eine schematische Darstellung eines in der Vorrichtung aus Fig. 8 fertiggestellten Solarmoduls.

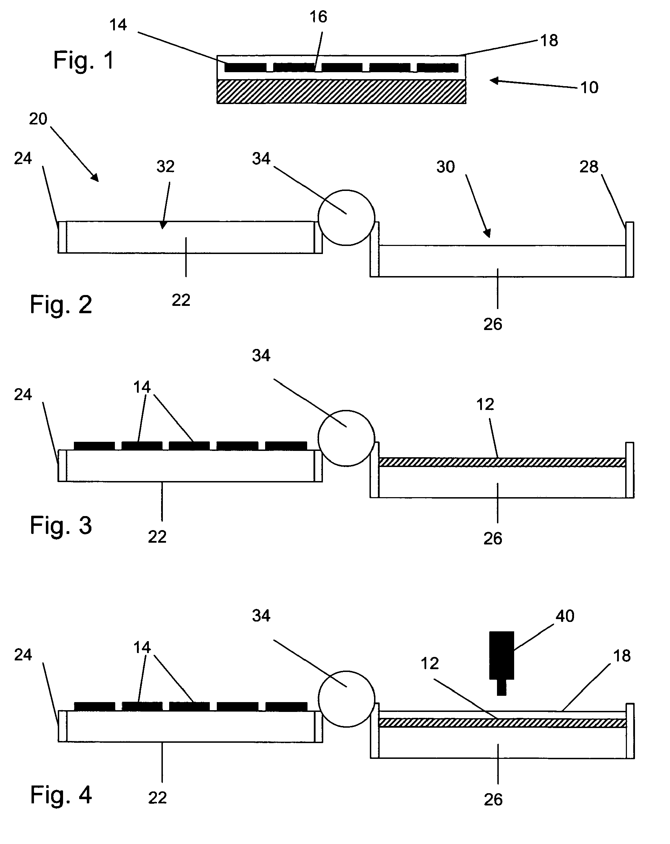

In Fig. 1 ist der Aufbau eines mit dem erfindungsgemäßen Verfahren hergestellten Solarmoduls 10 zu erkennen. Dabei sind in einer Polyurethanumhüllung 18 Photovoltaik-Zellen 14 vorgesehen, die untereinander mit Verbindungsleitungen 16 elektrisch verbunden sind. Die Photovoltaik-Zellen 14 sind von der Polyurethanumhüllung 18 vollständig ummantelt, wobei zumindest der Teil der Polyurethanschicht auf der Oberseite lichtdurchlässig ist. Die in die Polyurethanschicht 18 eingebetteten Photovoltaik-Zellen 14 sind aus Stabilitätsgründen auf einer Trägerstruktur 12 aufgebracht.

Bei der Herstellung dieses vorgenannten Solarmoduls 10 wird ein Formwerkzeug verwendet, wie es in Fig. 2 dargestellt ist. Dieses Formwerkzeug besitzt eine Formwerkzeughälfte 26 und eine Handlingsvorrichtung 22 in Form eines Aufprägewerkzeugs 22, die über ein Gelenk 34 miteinander schwenkbar um eine Achse verbunden sind. Um diese Achse ist das Formwerkzeug aufklappbar oder auch verschließbar.

Die Formwerkzeughälfte 26 besitzt an ihren Seiten nach oben geführte umlaufende Ränder, wobei in der Schnittdarstellung der Fig. 2 nur zwei Ränder in Form einer Schalungsstruktur 28 zu erkennen sind. Durch den umlaufenden Rand 28 ergibt sich bei dem Formwerkzeug 26 Aufnahme 30.

Wie aus Fig. 3 zu erkennen ist, wird in der Aufnahme 30 der zweiten Formwerkzeughälfte eine Trägerstruktur 18, beispielsweise aus Polycarbonat eingebracht, die diese Aufnahme 30 vollständig ausfüllt.

Auf die Oberfläche der Handlingseinrichtung 22 werden die Photovoltaik-Zellen 14 zusammen mit den dazwischen angeordneten Verbindungsleitungen 16 in der erforderlichen Weise positioniert, wobei die einzelnen Photovoltaik-Zellen 14 mit ihrer Oberseite vollflächig auf der Handlingseinrichtung 22 aufliegen.

Nach dieser Anordnung wird mittels eines Mischkopfes 40 (vgl. Fig. 3) ein Polyurethanmaterial in die Aufnahme 30 eingebracht, eingegossen oder aufgesprüht, welches sich aufgrund der geringen Viskosität gleichmäßig über die Trägerstruktur 12 verteilt und eine Beschichtung ausbildet.

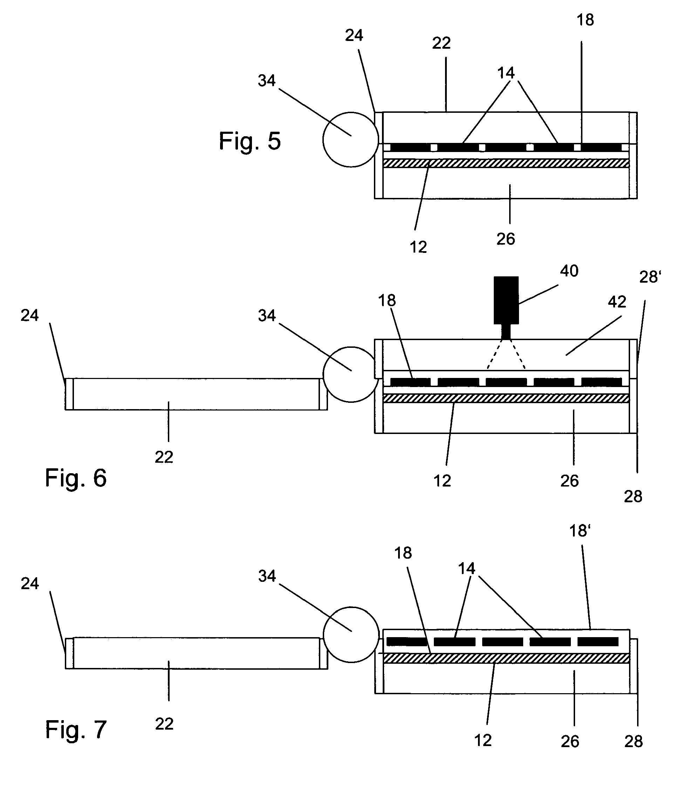

Nach diesem Schritt wird das Formwerkzeug zusammengeklappt, wie dies in Fig. 5 zu erkennen ist. Beim Vorgang des Zusammenklappens können die einzelnen Photovoltaik-Zellen mittels einer Vakuumeinrichtung (nicht dargestellt) gehalten werden.

Aufgrund der vollflächigen Auflage der Photovoltaik-Zellen 14 auf der Handlingseinrichtung 22 können Beschädigungen beim Aufbringen der Photovoltaik-Zellen 14 auf der beschichteten Trägerstruktur vermieden werden. Ist die Beschichtungsstruktur noch nicht vollständig ausgehärtet so ergibt sich zudem eine formschlüssige Verbindung zwischen jeder Photovoltaik-Zelle und der Beschichtung selbst. Überdies gelangt bei dieser Vorgehensweise kein Polyurethanmaterial an die spätere Oberseite der einzelnen Photovoltaik-Zellen. Nunmehr härtet das Polyurethanmaterial zumindest im Wesentlichen aus, so dass insgesamt eine ausreichende Festigkeit gegeben ist. Ausreichend kann dabei auch sein, dass die Viskosität eines Gels durch einen Temperaturabfall erreicht wird.

Im nächsten Schritt wird die Handlingseinrichtung 22 wieder zurückgeklappt, so dass die Photovoltaik-Zellen mit Ihrer Oberfläche nach oben frei zugänglich sind. Wie in Fig. 6 zu erkennen ist, wird nun ein Oberwerkzeug 42 auf die Werkzeughälfte 26 aufgesetzt, so dass zwischen der Beschichtung bzw. den Photovoltaik-Zellen und dem Oberwerkzeug 42 eine Kavität ausgebildet ist. In diese Kavität wird mittels des Mischkopfes 40 ein weiteres Polyurethan-Material eingefüllt, welches nunmehr die Photovoltaik-Zellen 14 überflutet. Dabei braucht das Oberwerkzeug nicht unbedingt eine geschlossene Kavität bilden. Es kann auch einfach eine Aufnahme für das nachfolgend eingefüllte Polyurethan-Material bilden.

Im letzteren Fall kann das Oberwerkzeug einfach zusätzliche Schalungsstrukturen 28' ausbilden die auf der erste Schalung 28 aufgebracht sind und diese somit nach oben verlängert. Dadurch ergibt sich eine weiter nach oben geführte Aufnahme, in die nun ein weiteres Polyurethanmaterial (Schicht 18') eingegossen oder aufgesprüht wird.

Zumindest bei diesem letzten Verfahrensschritt wird ein Polyurethanmaterial verwendet, welches im ausgehärteten Zustand lichtdurchlässig ist.

Nach dem Eingießen dieses Polyurethanmaterials wird entweder ein Vakuum an die Oberfläche des so hergestellten Solarmoduls angelegt oder mit einem Heizstrahler die Oberfläche beaufschlagt, um eventuelle Lufteinschlüsse aus der Polyurethanoberfläche auszutreiben.

Nach dem Aushärten des in dem letzten Verfahrensstand eingebrachten Polyurethanmaterials ist nun ein einheitliches Solarmodul gebildet, wie dies in Fig. 1 dargestellt ist. Dieses wird aus der Form entnommen und ist im Wesentlichen fertiggestellt.

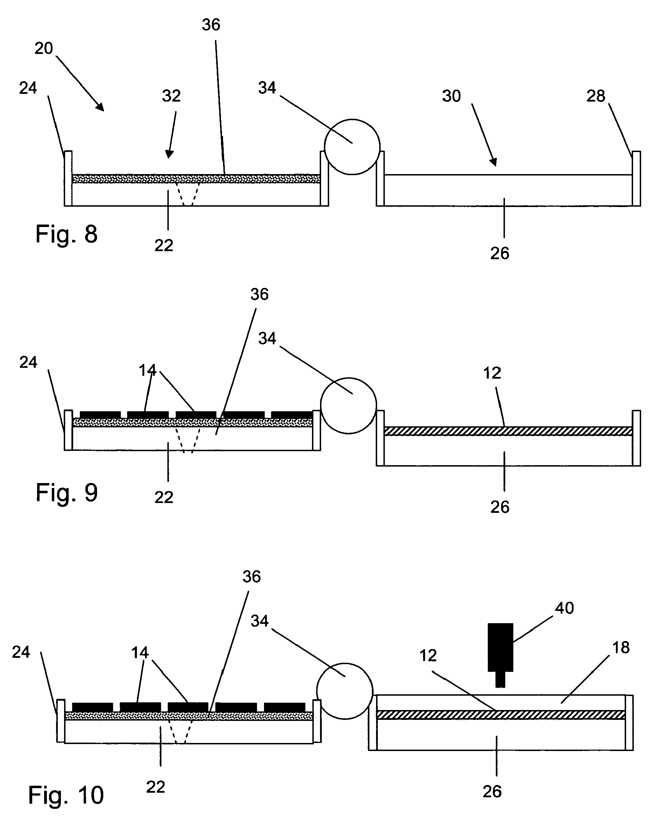

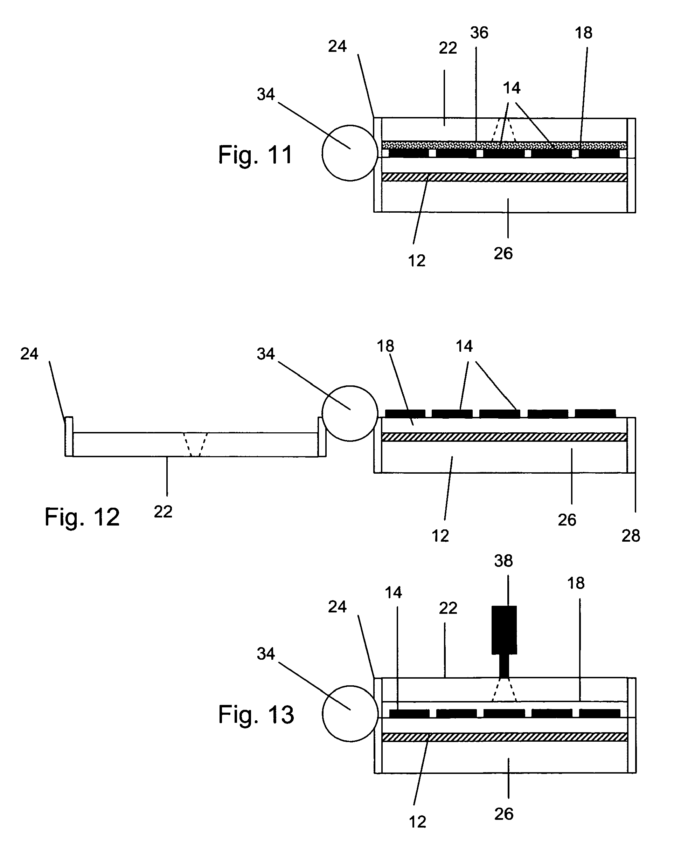

Die Ausführungsform in den Figuren 8 bis 13 unterscheidet sich nur geringfügig in derjenigen der Figuren 2 bis 7. Die Ausführungsform der die Trägerstruktur 12 aufnehmenden ersten Werkzeughälfte 26 ist identisch. Lediglich die zweite Werkzeughälfte 22 ist nun anders ausgebildet. In diese Werkzeughälfte 22 ist nämlich im ersten Schritt bereits eine Zellenträgerplatte 36 eingelegt auf die dann die Photovoltaik-Zellen aufgebracht werden. Alternativ kann die Zellenträgerplatte 36 gleich mit aufgebrachten und verdrahteten Photovoltaik-Elementen eingelegt werden.

Nach dem Aufbringen des Polyurethan-Materials auf die Trägerstruktur 12 erfolgt dann wieder in gleicher Weise der Schwenkvorgang der Photovoltaik-Elemente 14 auf die beschichtete Trägerstruktur. Anschließend wird die zweite Werkzeugplatte 22 wieder zurückverschwenkt und nunmehr die Zellenträgerplatte 36 entfernt. Damit entsteht ein Raum, der nach einem weiteren Zurückverschwenken die Kavität zumindest im Wesentlichen definiert. In diese Kavität wird dann das die Oberfläche des Solarmoduls definierende Beschichtung eingebracht. Nach dem Aushärten kann die Werkzeugform aufgeklappt und das Solarmodul entnommen werden.

Mit der vorliegenden Erfindung können auf einfache und schnelle Weise Solarmodule hergestellt werden, wobei die einzelnen Photovoltaik-Zellen beim Einbringvorgang des Polyurethanmaterials nicht beschädigt werden.

Beim Auf- und Einbringen der Polyurethanmaterialien können diese jeweils punkt-oder linienförmig aufgetragen werden, insbesondere mit einem Kleinmengenmischkopf.

Wie vorgenannt erwähnt, verläuft das Polyurethanmaterial aufgrund der niedrigen Viskosität und des flüssigen Zustands flächig.

Sollte bei einem Verfahrensschritt überschüssiges Material verdrängt werden, so kann dieses später beispielsweise durch einen Fräsvorgang oder einen Laserbeschnittvorgang abgetrennt werden.

Vorteilhaft ist insgesamt, dass mit dem erfindungsgemäßen Verfahren die Bruchgefahr beim Umschäumen der Matrizen eliminiert werden kann, da immer eine vollflächige Auflage gegeben ist.

Die Solarmodule können nachfolgend ggf. noch mit einer Folie beschichtet werden, die die Sonnenstrahlen besser verwertet oder auch noch einen Schutz vor der Witterung bietet. Alternativ dazu kann die Oberfläche des Moduls auch durch eine Plasma-Funktionsschicht ergänzt werden, die neben der Schutzfunktion gegen Wasser und Schmutz auch Konzentratorwirkung haben kann. Beispielsweise kann so eine Wasseraufnahme des Polyurethanmaterials verhindert werden.

Bei den Formwerkzeugen bzw. den mit dem Polyurethan in Kontakt kommenden Werkzeugteilen ist darauf zu achten, dass diese keine Haftung mit dem Polyurethanmaterial eingehen. Zu diesem Zweck könnten zumindest die mit dem Polyurethanmaterial in Verbindung kommenden Flächen aus Polypropylen gebildet sein.

Zum Abtrennen von überflüssigem Material können auch Quetschkanten vorgesehen sein, die beim Verschwenkvorgang der einen Werkzeughälfte auf die andere zum Einsatz kommen. Auch ist es möglich, die Auflage auf der einen oder anderen Formwerkzeughälfte mittels einer elastischen Matte, beispielsweise einer Schaumstoffmatte auszuführen, über die zum einen das Vakuum zum Fixieren des Trägers aufgebracht werden kann. Zum anderen würde diese elastische Unterlage als "sanfter" Druckspeicher hinsichtlich der Trägerstruktur zum Polyurethan wirken und diesen mit einer gewissen Kraft an das Polyurethan andrücken.

### Bezugszeichenliste

- 10: Solarmodul
- 12: Trägerstruktur
- 14: Photovoltaik-Zellen
- 16: Verbindungsleitungen
- 18: Polyurethanschicht
- 18': Polyurethanummantelung
- 20: Werkzeug
- 22: Handlingseinrichtung
- 26: erste Formwerkzeughälfte
- 28: Schalungsstruktur
- 28': Zusätzliche Schalungsstruktur
- 30: Aufnahme der ersten Formwerkzeughälfte
- 34: Gelenk
- 36: Zellenträgerplatte
- 40: Einbringeinheit (z.B. Mischkopf)
- 42: Oberwerkzeug als zweite Formwerkzeughälfte

## Patentansprüche

1. Verfahren zur Herstellung eines Solarmoduls mit den Schritten:
- Einbringen einer Trägerstruktur (12) in die Aufnahme (30) eines Formwerkzeugs (26),
- Überfluten der Trägerstruktur (12) mittels eines niedrigviskosen, vernetzenden Material (18), insbesondere mittels eines Polyurethan-Materials,
- zumindest teilweises Ausreagieren des vernetzenden Materials (18), wodurch die Trägerstruktur (12) zumindest teilweise beschichtet ist,
- Aufbringen von Photovoltaik-Zellen (14) auf die überflutete Trägerstruktur, wobei die Unterseiten der Photovoltaik-Zellen (14) vollflächig auf der Beschichtung aufliegen,
- Überfluten der Oberseiteseite der Photovoltaik-Zellen (14) mit einem niedrigviskosen vernetzenden Material (18'), welches im ausgehärteten Zustand lichtdurchlässig ist und
- Aushärten des vernetzenden, lichtdurchlässigen Materials.

2. Verfahren nach Anspruch 1,
**dadurch gekennzeichnet, dass**
die Trägerstruktur (12) aus Polycarbonat oder Styrol-Acrylnitril-Copolymer (SAN) gebildet wird.

3. Verfahren nach Anspruch 1 oder 2,
**dadurch gekennzeichnet,**
**dass** die Photovoltaik-Zellen (14) auf einer Handlingseinrichtung (22) fixiert werden und das Aufbringen der Photovoltaik-Zellen (14) auf die überflutete Trägerstruktur durch Zusammenfügen der beiden Formwerkzeughälften (22, 26) geschieht.

4. Verfahren nach einem der Ansprüche 1 bis 3,
**dadurch gekennzeichnet,**
**dass** zum vollständigen Überfluten der Oberseiteseite der Photovoltaik-Zellen (14) ein Oberwerkzeug auf dem zweiten Formwerkzeug unter Ausbildung einer Kavität positioniert wird.

5. Verfahren nach Anspruch 3 oder 4,
**dadurch gekennzeichnet,**
**dass** verschiedene Formwerkzeughälften (22, 26) zum Positionieren der Photovoltaik-Zellen (14) und/oder zum Ausbilden der Kavität aufeinander verschwenkt werden.

6. Verfahren nach einem der vorhergehenden Ansprüche,
**dadurch gekennzeichnet,**
**dass** vor dem Ausbilden einer Kavität ein Einsatzelement aus dem Oberwerkzeug entnommen wird.

7. Verfahren nach einem der vorgehenden Ansprüche,
**dadurch gekennzeichnet,**
**dass** das Aufbringen der Photovoltaik-Zellen (14) auf die überflutete Trägerstruktur (12) bei noch nicht vollständig ausreagiertem Zustand des vernetzenden Materials (18) durchgeführt wird, so dass die Photovoltaik-Zellen (14) zumindest geringfügig in das vernetzende Material eingedrückt oder verbindend aufgedrückt werden.

8. Verfahren nach einem der vorhergehenden Ansprüche,
**dadurch gekennzeichnet,**
**dass** überschüssiges, vernetzendes oder vernetztes Material abgetrennt wird.

9. Verfahren nach einem der vorhergehenden Ansprüche,
**dadurch gekennzeichnet,**
**dass** nach dem Aufbringen des vernetzenden Materials (18, 18') etwaige Lufteinschlüsse entfernt werden.

10. Verfahren nach Anspruch 9,
**dadurch gekennzeichnet,**
**dass** zur Entfernung der Lufteinschlüsse ein Vakuum angelegt wird.

11. Verfahren nach Anspruch 9,
**dadurch gekennzeichnet,**
**dass** zur Entfernung der Lufteinschlüsse eine Heizquelle verwendet wird, mit der Wärme an der Oberfläche appliziert wird.

12. Verfahren nach einem der vorhergehenden Ansprüche,
**dadurch gekennzeichnet,**
**das** vor oder nach dem Aufbringen des vernetzenden Materials (18, 18') weitere Schichten, insbesondere Folien oder Plasma-Funktionsschichten aufgebracht werden.

13. Verfahren nach einem der vorhergehenden Ansprüche,
**dadurch gekennzeichnet,**
**dass** die Trägerstruktur (12) und/oder das Zwischenprodukt und/oder die Photovoltaik-Zellen (14) zumindest während des Handlings mittels Unterdruck gehalten werden.

14. Verfahren nach einem der vorhergehenden Ansprüche,
**dadurch gekennzeichnet,**
**dass** die Photovoltaik-Zellen (14) vor dem Aufbringen auf die überflutete Trägerstruktur auf einer Folie angeordnet sind und dass diese Folie nach dem Aufbringen des vernetzenden Materials auf die Photovoltaik-Zellen (14) abgenommen wird.

15. Verfahren nach einem der vorhergehenden Ansprüche,
**dadurch gekennzeichnet,**
**dass** die Trägerstruktur (12) und/oder die Photovoltaik-Elemente (14) in Aufnahmen auf elastischen Unterlagen positioniert werden.

16. Vorrichtung zur Durchführung des Verfahrens nach einem der vorhergehenden Ansprüche, umfassend
ein erstes Formwerkzeugteil (26) zum Positionieren und Übergießen der Trägerstruktur (12),
eine Gießvorrichtung (40) zum Einbringen eines vernetzenden Materials auf die Oberfläche der Trägerstruktur (12),
ein Handlingsteil (22) zum Positionieren der Photovoltaik-Zellen (14) auf der überfluteten Trägerstruktur (12),
ein Formwerkzeugteil (42) zum Ausbilden eines Kavitäts- oder Aufnahmebereiches auf der beschichteten Trägerstruktur,
wobei mittels der oder einer weiteren Gießvorrichtung ein vernetzendes, im ausgehärteten Zustand lichtdurchlässiges Material (18') in den Aufnahmebereich einbringbar ist.

17. Vorrichtung nach Anspruch 16,
**dadurch gekennzeichnet,**
**dass** das Formwerkzeugteil (42) als Oberwerkzeug ausgestaltet ist, welches auf die Formwerkzeughälfte aufsetzbar ist, derart dass als Aufnahmebereich eine Kavität ausbildbar ist.

18. Vorrichtung nach Anspruch 16 oder 17,
**dadurch gekennzeichnet,**
**dass** Vakuumvorrichtungen vorgesehen sind, um die Photovoltaik-Zellen (14) und/oder die Trägerstruktur (12) in den jeweiligen Werkzeugteilen (22, 26) zu halten.

19. Vorrichtung nach einem der Ansprüche 16 bis 18,
**dadurch gekennzeichnet,**
**dass** eine Vakuumvorrichtung oder eine Heizeinrichtung zur Entfernung von Lufteinschlüssen aus dem vernetzenden Material (18, 18') vorgesehen sind.

20. Vorrichtung nach einem der Ansprüche 16 bis 19,
**dadurch gekennzeichnet,**
**dass** auflageseitig elastische Zellen in zumindest einem Werkzeugteil (22, 26) vorgesehen ist, auf dem die Photovoltaik-Zellen (14) und/oder die Trägerstruktur (12) positionierbar sind.
